# DEMANDE DE BREVET EUROPEEN

(11) **EP 1 039 544 A1**
(43) Date de publication de la demande: **27.09.2000**
(21) Numéro de dépôt: 00420046.5
(22) Date de dépôt: 21.03.2000
(51) Int. Cl.: H01L 23/522

(54) **Circuit intégré monolithique incorporant un composant inductif et procédé de fabrication d'un tel circuit intégré**

(30) Priorité: 23.03.1999 FR 9903762
(71) Demandeur: Memscap, 38330 Saint Ismier (FR); Planhead-Silmag Phs, 75008 Paris (FR)
(72) Inventeur: Basteres, Laurent, 38000 Grenoble (FR); Mhani, Ahmed, 38100 Grenoble (FR); Valentin, François, 38113 Veurey Voroize (FR); Karam, Jean-Michel, 38000 Grenoble (FR)
(74) Mandataire: Palix, Stéphane

(57) **Abrégé**

Circuit intégré monolithique (1) incorporant un composant inductif (2), comprenant :
- une couche de substrat semi-conducteur (2) ;
- une couche de passivation (4) recouvrant la couche de substrat (2) ;
- des plots de contact métalliques (5) connectés au substrat (2) et traversant la couche de passivation (4) pour affleurer sur la face supérieure (6) de la couche de passivation (4) ;
caractérisé en ce qu'il comporte également un enroulement en spirale (20) formant inductance, et disposé selon un plan parallèle à la face supérieure (6) de la couche de passivation (4), ledit enroulement (20) étant constitué de spires (21-23, 27, 28) en cuivre présentant une épaisseur supérieure à 10 microns, les extrémités de l'enroulement formant des prolongements (12) s'étendant sous le plan de l'enroulement (20), et étant connectées aux plots de contact (5).

## Description

### Domaine technique

L'invention se rattache au domaine de la micro-électronique. Plus précisément, elle concerne les circuits intégrés monolithiques incluant des composants inductifs tels que ceux notamment utilisés pour des applications de télécommunications par radiofréquences.

Elle concerne également un procédé de fabrication de tels composants, qui permet d'obtenir des circuits compacts et présentant des caractéristiques électriques, et notamment un facteur de qualité, supérieures à celles des composants existant.

### Techniques antérieures

Comme on le sait, les circuits intégrés sont de plus en plus utilisés dans les techniques des micro-ondes et des radiofréquences.

Dans ces applications, il est important de pouvoir utiliser des circuits oscillants accordés, constitués par un ensemble capacité-inductance.

Or, de tels circuits doivent être réalisés dans des volumes de plus en plus réduits. En outre, ils doivent fonctionner à des fréquences de plus en plus élevées. Par conséquent, la consommation électrique de tels composants devient un paramètre critique, par exemple dans les téléphones portables cellulaires, car la consommation influe directement sur l'autonomie de ces appareils.

Ainsi, il est demandé aux composants passifs constituant les filtres utilisés dans les systèmes radiofréquences, et notamment les inductances, d'occuper une surface aussi faible que possible à l'intérieur des circuits intégrés, de présenter une valeur d'inductance aussi élevée que possible, et d'induire une consommation électrique aussi faible que possible.

En outre, on sait que les inductances implantées à l'intérieur de circuits intégrés en matériau semi-conducteur subissent l'influence de capacités parasites constituées par les différentes zones de substrat localisées au voisinage des inductances.

Ainsi, en pratique, une inductance présente un schéma équivalent dans lequel, à cette inductance proprement dite, s'ajoutent différents composants parasites écartant cette inductance de son comportement idéal.

Ainsi, une inductance réelle présente une résistance correspondant à celle du métal qui la compose.

En outre, le comportement électrique de l'inductance est perturbé par des capacités parasites qui résultent de différentes couches de matériaux de mauvaise permittivité électrique, situées au-dessus du substrat.

En outre, aux capacités parasites de ces différentes couches, s'ajoutent une capacité et une résistance parasite correspondant à l'influence du substrat semi-conducteur situé au dessus du plan de masse.

En outre, une capacité parasite existe entre les différentes spires constituant l'inductance.

Dans le document EP 0 969 509, Le Demandeur a décrit une solution permettant de réaliser de telles inductances sur un substrat semi-conducteur, en adoptant une disposition permettant de réduire fortement la valeur de la capacité parasite existant entre spires. Une telle solution consiste à réaliser l'inductance par un ruban métallique déposé sur le substrat, et à graver ledit substrat pour ménager une cavité en dessous du ruban formant inductance, et ainsi à suspendre et éloigner l'inductance du substrat.

Grâce à ces dispositions, il est possible d'utiliser des inductances à des fréquences plus élevées tout en conservant un comportement satisfaisant. On rappelle que la fréquence optimale de fonctionnement est déterminée comme étant celle où le facteur de qualité est maximum. Le facteur de qualité est déterminé de façon connue par le rapport entre la partie imaginaire ou réactance, et la partie réelle de l'impédance d'entrée d'une inductance.

La solution décrite dans le document précité, bien que satisfaisante, ne permet pas d'améliorer de façon notable, le facteur de qualité dans les plages de fréquences basses, c'est-à-dire situées en dessous de la moitié de la fréquence optimale, qui est dans les applications typiques de l'invention, proche de quelques gigahertz.

En effet, dans cette gamme de fréquence, le comportement de l'inductance est fortement dépendant de la valeur de la résistance équivalente, qui correspond à la résistance électrique du ruban métallique constituant l'inductance proprement dite.

Or, toutes les inductances réalisées dans les circuits intégrés, sont aujourd'hui constituées d'aluminium, et présentent des dimensions faibles, et surtout une épaisseur très faible, typiquement inférieure à 4 microns, ce qui se traduit par une résistance électrique élevée.

Ainsi, un des problèmes que se propose de résoudre l'invention est celui de l'influence néfaste de la résistance globale de l'enroulement formant inductance, tout en conservant des caractéristiques électriques avantageuses, notamment en termes de capacité parasite.

De nombreux documents, tels que notamment les documents US 5 874 883, EP 0 782 190 ou US 5 834 825, décrivent des circuits intégrés qui comportent à leur surface des inductances constituées d'un ruban métallique. Ces dispositifs présentent les avantages précités concernant un faible facteur de qualité lorsque le ruban métallique est d'épaisseur classique, de l'ordre de quelques microns. En outre, ces inductances sont réalisées pendant le procédé de fabrication du circuit intégré proprement dit, ce qui augmente les contraintes technologiques car leur implantation doit être prise en compte dans les étapes du procédé. Enfin et surtout, de telles inductances occupent une certaine surface sur le substrat semi-conducteur. Cette surface utilisée par l'inductance ne peut donc pas servir à implanter des zones actives dans le semi-conducteur, ce qui diminue la densité utile de ce dernier.

Dans le document US 5 478 773, on a proposé de réaliser une inductance sur un substrat, en formant un ruban de cuivre par attaque chimique d'une couche de cuivre. Malheureusement, pour former les spires de l'inductance, il est nécessaire de procéder à un premier dépôt d'une couche de croissance de cuivre pulvérisé, puis d'une seconde couche de cuivre électrolytique. On procède ensuite à une gravure différentielle qui attaque préférentiellement le cuivre pulvérisé par rapport au cuivre électrolytique. Cette gravure différentielle est nécessaire pour ne pas endommager les parties de cuivre électrolytique qui forment les spires. De telles précautions opératoires compliquent le procédé et ne permettent pas d'obtenir des spires de taille suffisante pour améliorer nettement le facteur de qualité.

### Exposé de l'invention

L'invention concerne donc un circuit intégré monolithique incorporant un composant inductif, et comprenant :
- une couche de substrat semi-conducteur ;
- une couche de passivation recouvrant la couche de substrat ;
- des plots de contact métalliques connectés au substrat et traversant la couche de passivation pour affleurer sur la face supérieure de la couche.

Ce circuit intégré se caractérise en ce qu'il comporte également un enroulement en spirale formant inductance, et disposé selon un plan parallèle à la face supérieure de la couche de passivation, ledit enroulement étant constitué de spires en cuivre présentant une épaisseur supérieure à 10 microns, les extrémités de l'enroulement formant des prolongements s'étendant sous le plan de l'enroulement, et étant connectées aux plots de contact.

Autrement dit, l'inductance est montée directement sur le circuit intégré, au-dessus de la couche de passivation. Elle est formée juste après le processus de réalisation du circuit intégré lui-même. Il est donc possible de la créer sur des wafers de provenance très diverse, puisque sa réalisation est dissociée des opérations de fabrication du circuit intégré proprement dit.

Une telle inductance est disposée au dessus du circuit intégré et non pas sur le circuit intégré, de sorte que la surface du circuit intégré située à l'aplomb de l'inductance peut comprendre des zones actives en plus des plots de contact. La densité de fonctions sur le circuit intégré n'est donc pas diminuée par la présence de l'inductance.

L'utilisation de cuivre pour la réalisation de l'enroulement permet de diminuer très fortement la résistance équivalente de l'inductance. Cette réduction est encore accentuée par l'utilisation de spires d'épaisseur largement supérieure à celle des rubans métalliques actuellement utilisés.

De la sorte, la résistance équivalente est très fortement réduite, typiquement d'un facteur dix par rapport à la résistance des inductances aujourd'hui réalisées dans les circuits intégrés.

Il s'ensuit que le facteur qualité est très largement supérieur à celui des inductances aujourd'hui existantes, et notamment dès les basses fréquences.

Typiquement, le facteur de qualité de telles bobines est supérieur d'un facteur environ dix au facteur de qualité des inductances existantes.

Avantageusement en pratique, le plan selon lequel est disposé l'inductance est distant de la face supérieure de la couche de passivation, d'une distance supérieure à 10 microns.

En effet, on a constaté qu'il est important que l'inductance proprement dite soit suffisamment éloignée du substrat pour limiter les phénomènes de pertes électriques à l'intérieur du substrat, observées aux fréquences de fonctionnement des circuits selon l'invention. Cette distance ne doit pas néanmoins être trop grande, au risque de déstabiliser mécaniquement l'inductance.

Ainsi, pour une distance supérieure à 10 microns, et préférentiellement voisine de 30 microns, on limite les pertes électriques dans le substrat tout en assurant une bonne stabilité mécanique.

Dans une première variante de réalisation, le composant comprend une couche de support en benzocyclobutène sur laquelle repose l'enroulement formant inductance. De la sorte, l'inductance est stabilisée mécaniquement sur la couche de support, ce qui évite aux différentes spires de l'inductance de vibrer les unes par rapport aux autres, ce qui assure une bonne rigidité mécanique.

Dans une seconde variante de réalisation, la couche de support sur laquelle repose l'enroulement formant inductance est réalisée en silice .Selon deux formes d'exécution, la couche de support en silice est séparée de la face supérieure de la couche de passivation
soit par une couche de polyimide, ou tout autre polymère diélectrique;
soit par une couche d'air.

Dans cette dernière forme d'exécution, les propriétés électriques sont optimisées puisque la permittivité électrique de l'air est inférieure à celle du polyimide.

Selon une autre caractéristique de l'invention, l'enroulement en cuivre peut être recouvert d'une couche d'or ou d'alliage à base d'or, destinée à assurer la passivation du cuivre, et à interdire les phénomènes d'oxydation du cuivre qui viendraient en dégrader les caractéristiques de résistance électrique, notamment dans le cas où le circuit intégré est utilisé dans des atmosphères humides, voire chimiquement agressives.

Selon une autre caractéristique de l'invention, l'espace entre deux spires consécutives de l'enroulement est exempt de matière, ou plus précisément empli d'air, ce qui diminue fortement la capacité parasite existant entre chaque spire, et augmente donc la fréquence optimale de fonctionnement de l'inductance.

Comme déjà dit, l'invention concerne également un procédé de fabrication d'un circuit intégré monolithique incorporant un composant inductif. Ainsi, à partir d'un substrat semi-conducteur recouvert d'une couche de passivation, et comprenant des plots métalliques connectés au substrat, et traversant la couche de passivation pour affleurer sur la face supérieure de ladite couche, le procédé conforme à l'invention se caractérise en ce qu'il comprend les étapes suivantes, dans lesquelles :
- on dépose une couche de polyimide sur la couche de passivation ;
- on dépose une couche de silice sur ladite couche de polyimide ;
- on aménage des ouvertures dans les couches de silice et de polyimide, les dites ouvertures débouchant sur les plots métalliques ;
- on dépose sur l'ensemble une sous-couche de métal de croissance ;
- on dépose sur la sous-couche de métal de croissance, une couche de résine photosensible ;
- on insole la résine et on élimine les zones destinées à former la face inférieure du composant inductif ;
- on dépose par électrolyse sur les zones apparentes de la sous-couche de métal de croissance, une couche de cuivre destinée à former le ruban du composant inductif ;
- on élimine le reste de la résine photosensible et la sous-couche de métal de croissance.

Autrement dit, le procédé conforme à l'invention permet de réaliser directement sur le circuit intégré, les inductances nécessaires au bon fonctionnement du circuit, à la suite du processus de fabrication du circuit intégré proprement dit.

De la sorte, les enroulements des inductances sont toutes réalisées simultanément, au cours d'une série d'étapes constituant une prolongation du procédé de fabrication du circuit intégré lui-même. Il n'est donc pas nécessaire de faire appel à des opérations de report ultérieur qui consisteraient à connecter des inductances réalisées par ailleurs sur un circuit intégré fini.

Selon une variante de réalisation, le procédé comporte une étape supplémentaire d'élimination de la couche de polyimide, aboutissant à un composant dont l'inductance est suspendue au-dessus de la couche de passivation.

Bien évidemment, l'invention couvre également le procédé dans lequel la couche de polyimide est conservée pour notamment assurer une stabilité de l'inductance.

Selon une variante de réalisation, les deux couches de polyimide et de silice sont remplacées par une unique couche de benzocyclobutène, ou tout autre matériau équivalent à très faible constante diélectrique.

Comme déjà dit, le procédé peut également inclure une étape de passivation du ruban de cuivre par dépôt d'une couche d'or, ou d'alliage à base d'or. Néanmoins, dans une mise en oeuvre moins perfectionnée du procédé, on peut prévoir de recouvrir les spires d'une simple couche de passivation classique.

Avantageusement en pratique, le procédé peut inclure une étape de dépôt d'un métal formant couche barrière sur le plot métallique. De la sorte, on élimine les phénomènes de migration du cuivre en direction de l'aluminium, dont on sait qu'ils peuvent induire des dégradations de la couche active du substrat semi-conducteur.

Avantageusement, le procédé comporte postérieurement à l'étape de dépôt de la couche barrière, une étape de dépôt d'une couche d'adaptation sur la couche de métal barrière. Cette étape permet d'optimiser le contact et favorise l'adhérence intermetallique tout en limitant les capacités parasites apparaissant au niveau des jonctions métalliques.

### Description sommaire des figures

La manière de réaliser l'invention ainsi que les avantages qui en découlent ressortiront bien de la description des modes de réalisation qui suivent, à l'appui des figures annexées, dans lesquelles :

La figure 1 est une vue en coupe schématique d'un circuit intégré conforme à l'invention, dans la zone où est implantée l'inductance caractéristique.

La figure 2 est une même vue en coupe réalisée pour une variante de réalisation.

La figure 3 est une même vue en coupe réalisée pour une autre variante de réalisation.

Les figures 4 à 6 sont des mêmes vues en coupe réalisées pour différentes étapes du procédé conforme à l'invention.

Les figures 7 et 8 sont deux mêmes vues en coupe illustrant deux variantes différentes d'exécution du procédé conforme à l'invention.

### Manière de réaliser l'invention

Comme déjà dit, l'invention concerne un composant inductif tel qu'une bobine ou un transformateur, incorporé dans un circuit intégré monolithique.

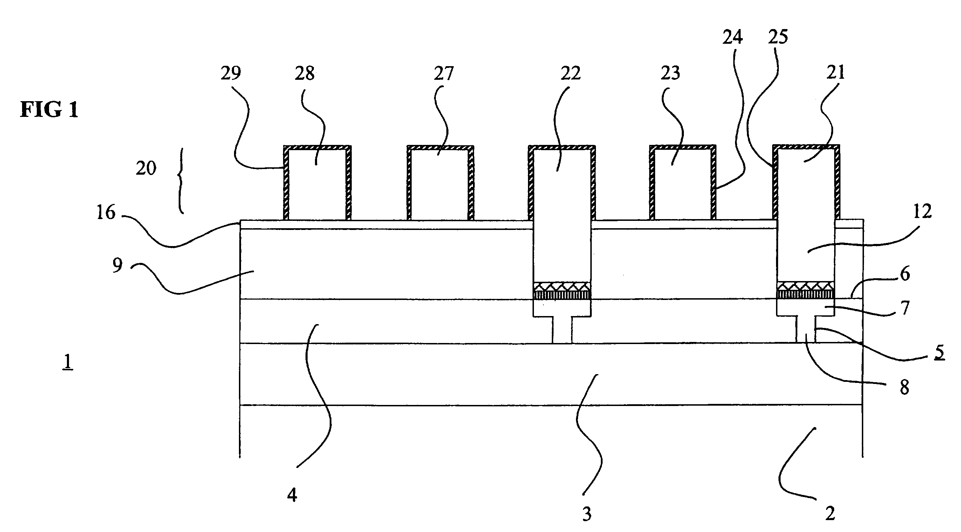

Ainsi, comme illustré à la figure 1, le circuit intégré (1) comporte un substrat (2) en matériau semi-conducteur, typiquement du silicium ou analogue.

Dans sa partie supérieure le substrat semi-conducteur (2) inclut une zone active (3) ayant subi différentes étapes de croissance et de dopage permettant au circuit intégré d'assurer ses fonctions électroniques, ainsi que des niveaux métalliques dédiés au cablage entre les différents transistors ou fonctions électroniques réalisées.

Ce substrat semi-conducteur (2) est recouvert d'une couche de passivation (4), typiquement constituée en un alliage d'oxyde et de nitrure ou tout autre passivant diélectrique. Cette couche de passivation (4) a une épaisseur de plusieurs microns. Elle est traversée par une pluralité de plots de contact métalliques (5), réalisés en aluminium, et qui permettent la connexion au substrat semi-conducteur (2) depuis la face supérieure (6) de la couche de passivation (4).

Ainsi, en pratique, ces plots de contact (5) affleurent au niveau de la face supérieure (6) de la couche de passivation (4) en occupant une surface proche d'un carré (7) de quelques dizaines de microns de côté. Ces plots présentent une section réduite (8) au niveau de la zone de connexion avec la zone active (3) du substrat semi-conducteur.

Conformément à l'invention, dans la forme de réalisation illustrée à la figure 1, la couche de passivation (4) est recouverte d'une couche de polyimide (9).

Le polyimide est notamment utilisé pour sa faible permittivité électrique qui limite la capacité parasite de l'inductance conforme à l'invention.

Cette couche de polyimide (9) a une épaisseur supérieure à 10 microns, et est préférentiellement voisine de 30 microns.

Au niveau de l'aplomb des plots de contact (5), la couche de polyimide (9) est traversée par des segments (12) d'une section voisine à celle de la partie supérieure (7) des plots de contact (5). Ces segments (12) sont, conformément à l'invention, réalisés en cuivre.

Ces segments constituent les extrémités de l'enroulement (20) formant inductance, et qui est disposé au-dessus d'une couche de silice (16), elle-même disposée sur la couche de polyimide (9).

L'enroulement (20) forme une spirale, dont la géométrie peut être polygonale, ou préférentiellement circulaire. Ainsi, les segments (12) connectés aux plots de contact (5) forment des prolongements vers le bas des extrémités de l'inductance (20), et typiquement de l'extrémité (21) de la spire extérieure et de l'extrémité centrale (22) de la spirale.

Avantageusement en pratique, les spires en cuivre (21-23) de l'enroulement présentent une épaisseur supérieure à 10 microns, et de préférence voisine de 30 microns.

Ces spires (21-23) épousent une section rectangulaire, de manière à présenter vis à vis de la spire adjacente une surface plane. L'espace entre deux faces (24, 25) de spires adjacentes est empli d'air, ce qui limite la capacité parasite entre spires.

Avantageusement en pratique, la distance entre spires est également voisine de 30 microns.

Compte tenu des risques d'oxydation inhérents au fonctionnement en atmosphère humide ou chimiquement agressive, les spires de cuivre sont recouvertes d'une couche d'or (29) ou d'alliage à base d'or, d'une épaisseur voisine de 1000 Å.

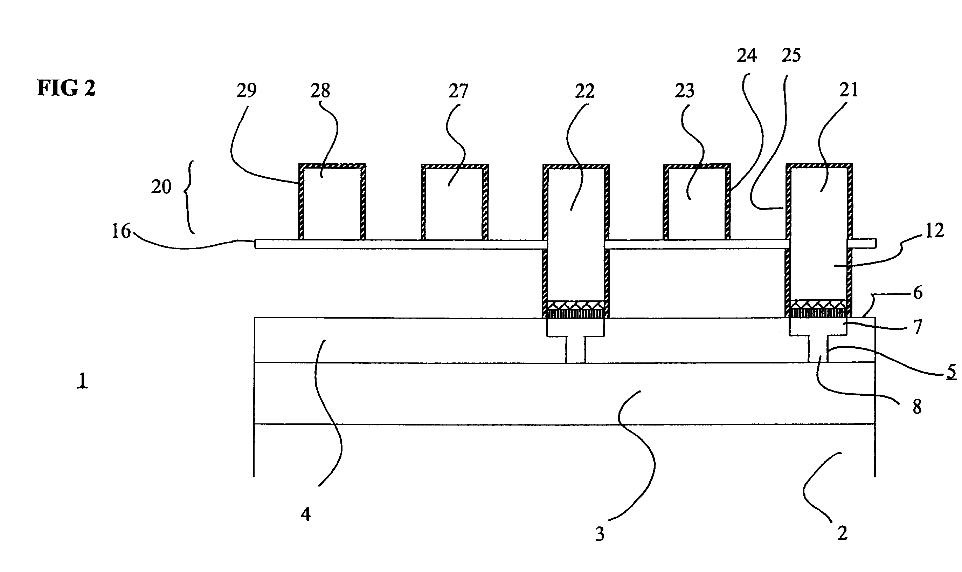

Dans la variante de réalisation illustrée à la figure 2, l'espace compris entre la couche de silice (16) et la couche de passivation (4) est exempt de matière, ce qui limite la valeur de la capacité parasite entre la bobine (20) et le plan de masse, ainsi que la capacité entre spires (21-23).

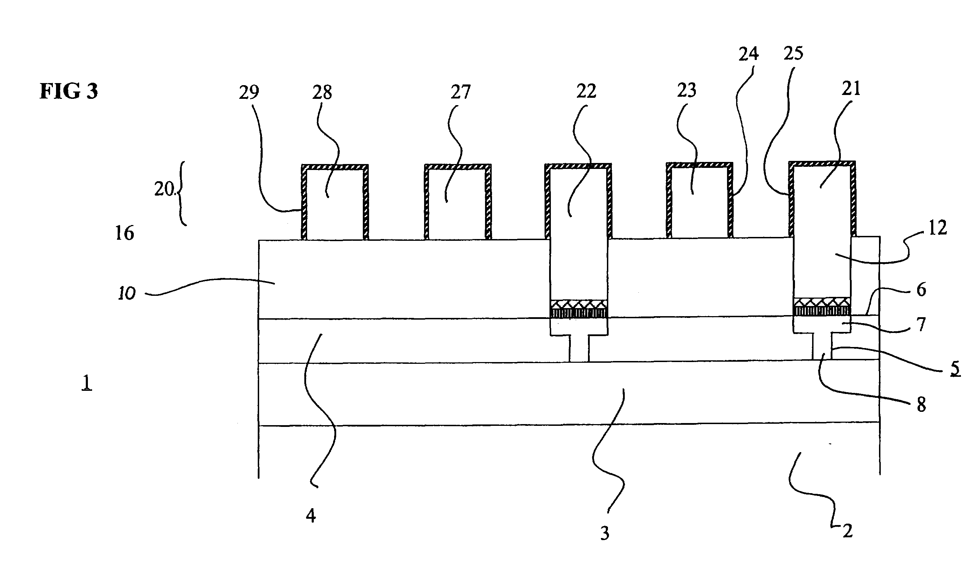

Dans la forme de réalisation illustrée à la figure 3, l'inductance (20) repose sur une couche de benzocyclobutène (10). Cette couche de benzocyclobutène (10) repose directement sur la face supérieure (6) de la couche de passivation. (4). Le benzocyclobutène est choisi notamment pour sa faible permittivité électrique qui limite les capacités parasites entre l'inductance (20) et la couche de passivation (4), ainsi que pour sa bonne tenue à l'humidité.

Comme déjà dit, l'invention concerne un procédé de réalisation de composants tels que précédemment illustrés.

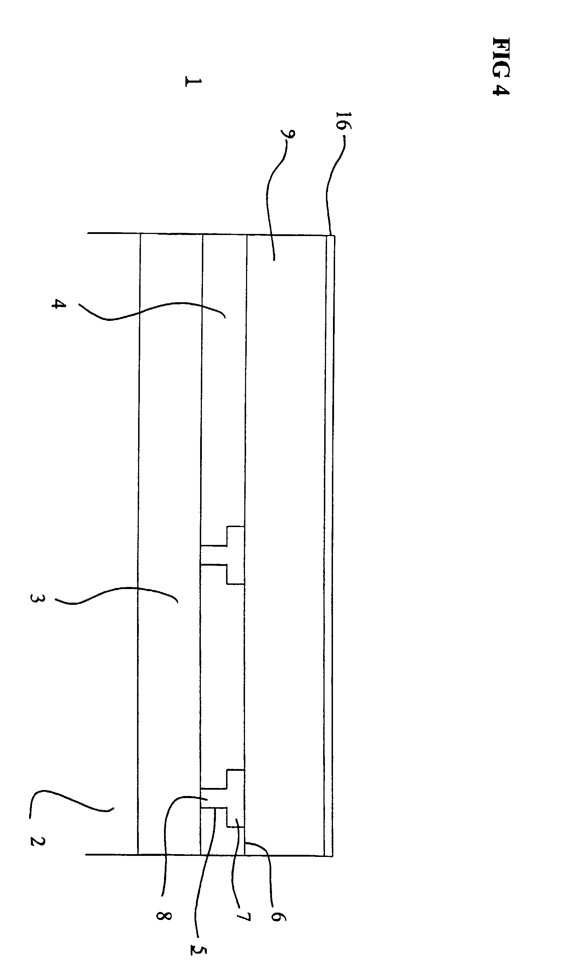

Ainsi, comme illustré à la figure 4, le procédé est réalisé sur un circuit intégré comprenant une couche de substrat semi-conducteur (2) sur laquelle a été formée la couche active (3), et au-dessus de laquelle a été déposée une couche de passivation (4) réalisée en un alliage d'oxyde et de nitrure ou tout autre passivant diélectrique.

Cette couche de passivation (4) est traversée par des plots métalliques (5) d'une part, connectés au substrat semi-conducteur (2), et d'autre part, affleurant à la face supérieure (6) de la couche de passivation (4).

Ainsi, la première étape du procédé conforme à l'invention consiste à déposer une couche de polyimide (9) sur la couche de passivation (4) de la totalité de la galette ou la pastille préalablement formée, et généralement dénommée "wafer".

Après avoir déposé la couche de polyimide (9) sur une épaisseur de 30 microns environ, on dépose une couche de silice (16) destinée à assurer un bon accrochage des dépôts métalliques sur la face supérieure de l'ensemble.

Selon une autre variante d'exécution aboutissant au circuit illustré à la figure 3, la couche de passivation est recouverte d'une couche de benzocyclobutène, choisi à la fois pour sa faible permittivité électrique, son pouvoir planarisant et son aptitude à recevoir les dépôts métalliques.

Par la suite, on crée des ouvertures (30) à l'intérieur des couches de silice (16) et de polyimide (9) de manière à laisser apparaître les plots de contact (5).

Selon une caractéristique de l'invention, on réalise un dépôt de nickel (31) sur la totalité de l'ensemble et notamment au-dessus des plots de contact (5). Ce nickel (31) est destiné à servir de couche barrière et interdire la migration du cuivre qui formera l'inductance en direction de la zone active (3) du substrat semi-conducteur (2).

Selon une autre caractéristique de l'invention, on dépose sur la couche de métal barrière (31), une seconde couche de métal (32) servant de couche d'adaptation, et typiquement réalisée en alliage nickel-or ou chrome-cuivre.

Typiquement, la couche de métal barrière présente une épaisseur voisine de 2000 Å.

Cette seconde couche de métal (32) ou couche d'adaptation a pour fonction de limiter les capacités parasites qui apparaissent au niveau des jonctions métalliques et de favoriser l'adhésion intermétallique.

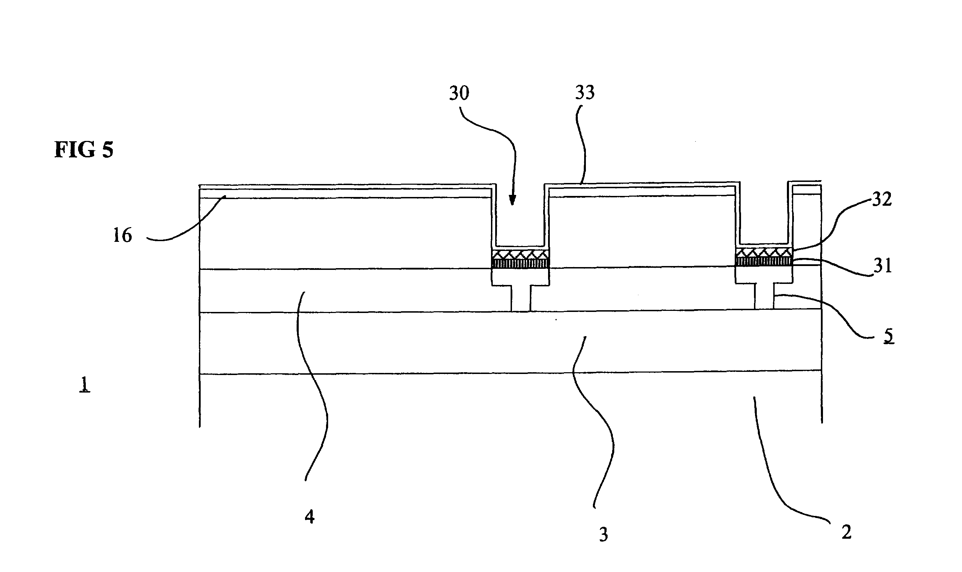

Ensuite, conformément à l'invention on réalise le dépôt d'une sous-couche de métal de croissance (33) sur la totalité de l'ensemble, pour aboutir à la forme illustrée à la figure 5. Cette sous-couche de métal de croissance est réalisée en alliage de chrome-cuivre, et présente une épaisseur typique de 2000 Å.

Par la suite, on procède au dépôt d'une résine photosensible sur la sous-couche de métal de croissance (33). On insole ensuite la résine en fonction du schéma souhaité et de la géométrie de l'inductance.

Ainsi, en fonction du masque choisi, la résine est ensuite développée à la forme des lignes qui formeront l'enroulement.

Par la suite, on procède au dépôt du cuivre (35) par croissance électrolytique, et à partir des zones dans lesquelles la sous-couche de métal de croissance est apparente.

Au niveau de la couche de silice de planarisation (16) le cuivre se dépose pour former les segments (23, 27, 28) formant la principale partie de l'inductance. Le dépôt électrolytique de cuivre a également lieu au-dessus des couches barrière (31) et d'adaptation (32) qui ont été déposées sur les plots de contact (5).

Les flancs de la résine présentent une hauteur telle qu'ils canalisent la croissance du cuivre, en garantissant la verticalité des faces (24, 25) en regard des spires adjacentes.

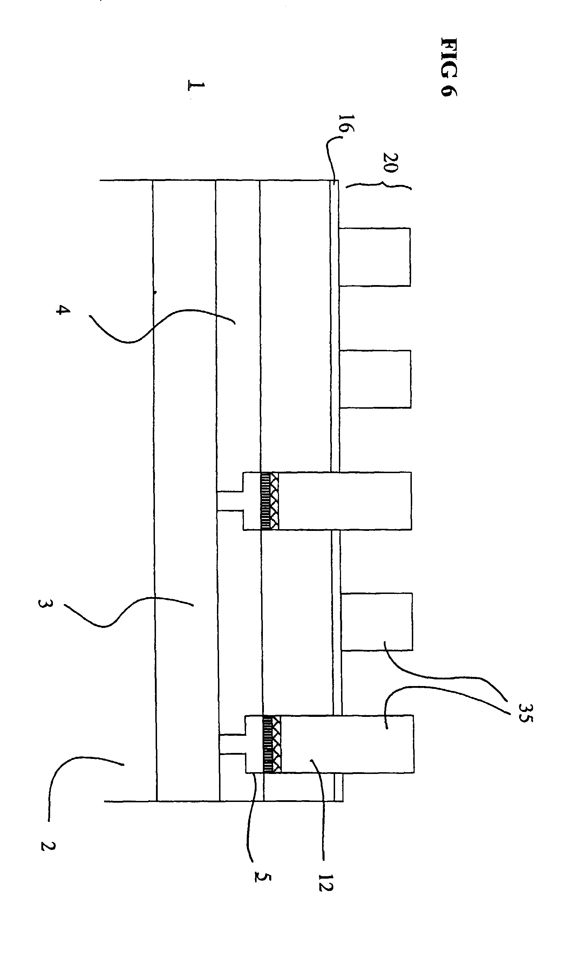

Lorsque les spires de cuivre (21-23, 27, 28) déposées électrolytiquement atteignent la hauteur voulue, soit environ 30 microns, on procède ensuite à l'élimination de la résine restante ainsi que de la sous-couche de métal de croissance qui était protégée par ladite résine, pour aboutir à l'état illustré à la figure 6.

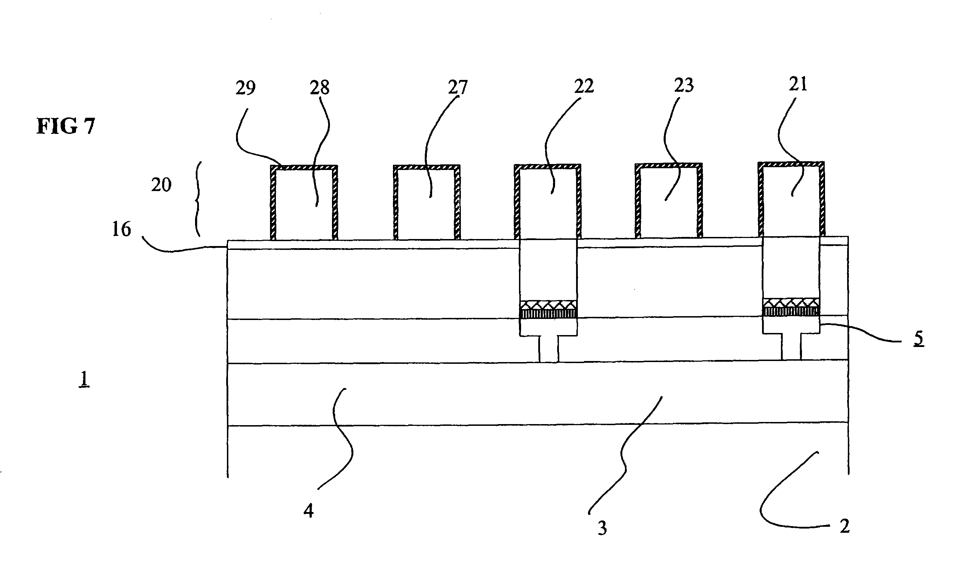

Par la suite, comme illustré à la figure 7, on procède à un dépôt d'une couche d'or (29), typiquement d'une épaisseur de 1000 Å sur les spires de cuivre (21-23, 27, 28), et plus précisément sur toutes les faces de ces spires destinées à venir au contact avec le milieu extérieur.

Le dépôt de cette couche d'or (29) ou d'alliage à base d'or, permet d'éliminer tout risque d'oxydation du cuivre qui dégraderait les performances électriques de l'inductance.

On obtient ainsi l'inductance telle qu'illustrée à la figure 7, correspondant sensiblement à l'inductance de la figure 1.

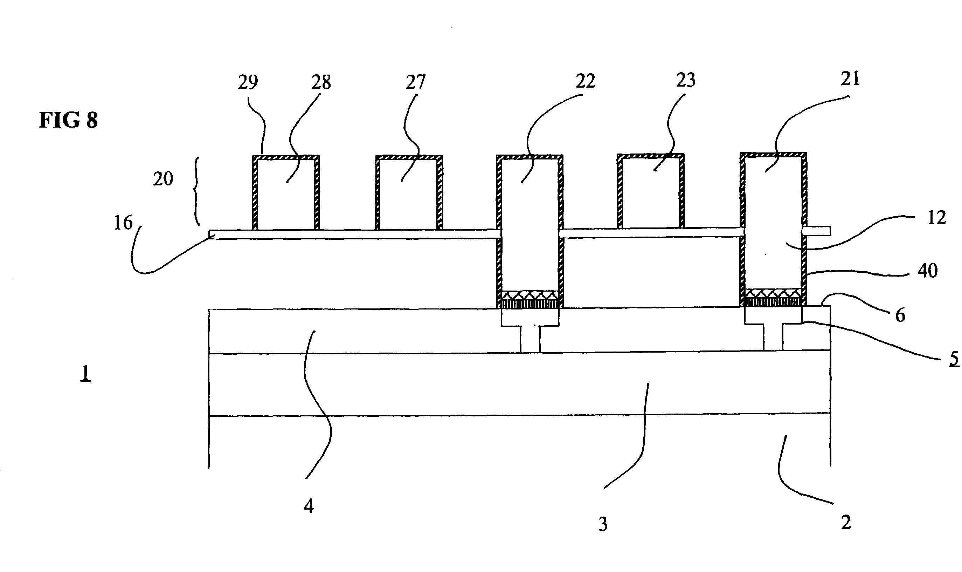

Dans une variante de réalisation illustrée à la figure 8, le procédé conforme à l'invention présente une étape supplémentaire destinée à éliminer la couche de polyimide située entre la couche de silice de planarisation (16) et la couche de passivation (4). Cette étape permet d'éliminer toute matière présente entre l'inductance (20) et le circuit intégré proprement dit, ce qui améliore les propriétés électriques en diminuant fortement les valeurs des capacités parasites tant entre l'inductance et la masse, qu'entre les spires de l'inductance elle-même.

Dans ce cas de figure illustré à la figure 8, l'étape de passivation du cuivre par dépôt d'une couche d'or intervient après l'élimination du polyimide, de manière à ce que les segments (12) de l'inductance formant les extrémités de la bobine soient également recouvertes de cette couche d'or de protection (40).

Bien entendu, l'invention couvre également les variantes de circuit intégré incorporant des transformateurs constitués de plusieurs enroulements enroulés de façon imbriquée les uns dans les autres.

Il ressort de ce qui précède que le circuit intégré conforme à l'invention permet d'obtenir des circuits électriques incorporant des inductances aptes à fonctionner à des fréquences élevées, supérieures à plusieurs gigahertz, et présentant un facteur de qualité largement supérieur aux circuits existants, typiquement d'un facteur dix, et ceci dans toute la gamme de fréquence.

La mise en place de l'inductance directement au-dessus de la couche de passivation du circuit intégré, dans une seule et unique étape permet d'augmenter la compacité de l'ensemble, sans nécessité de prévoir de zone inactive sur le circuit intégré.

Le procédé conforme à l'invention permet la fabrication de circuits intégrés comprenant des composants inductifs sans nécessiter de modifications profondes du processus de fabrication, puisque les inductances ou les composants inductifs sont réalisées directement à la suite du processus de fabrication du circuit intégré proprement dit.

Aucune étape de mise en place de composants inductifs réalisés par ailleurs n'est donc nécessaire, ce qui élimine toute opération de report dont on sait que la précision est limitée, et qui en tout état de cause induirait des dégradations des propriétés mécaniques dues aux zones de jonction par soudure ou brasage.

Un tel procédé est en outre réalisé à température inférieure à 400°C, ce qui évite les risques de dégradation de la couche active du substrat..

### Applications industrielles

Les circuits intégrés conformes à l'invention peuvent trouver de multiples applications, et notamment dans tous les circuits incluant des oscillateurs, des amplificateurs, des mixeurs ainsi que dans tout filtre actif ou passif.

L'association avec des circuits intégrés trouve une application toute particulière dans les montages électroniques destinés au traitement des télécommunications, des micro-ondes et des radiofréquences.

## Revendications

1. Circuit intégré monolithique (1) incorporant un composant inductif (2), comprenant :
- une couche de substrat semi-conducteur (2) ;
- une couche de passivation (4) recouvrant la couche de substrat (2) ;
- des plots de contact métalliques (5) connectés au substrat (2) et traversant la couche de passivation (4) pour affleurer sur la face supérieure (6) de la couche de passivation (4) ;
caractérisé en ce qu'il comporte également un enroulement en spirale (20) formant inductance, et disposé selon un plan parallèle à la face supérieure (6) de la couche de passivation (4), ledit enroulement (20) étant constitué de spires (21-23, 27, 28) en cuivre présentant une épaisseur supérieure à 10 microns, les extrémités de l'enroulement formant des prolongements (12) s'étendant sous le plan de l'enroulement (20), et étant connectées aux plots de contact (5).

2. Circuit intégré monolithique selon la revendication 1, caractérisé en ce que le plan selon lequel est disposé l'enroulement en spirale est distant de la face supérieure (6) de la couche de passivation (4) d'une distance supérieure à 10 microns.

3. Circuit intégré monolithique selon la revendication 1, caractérisé en ce qu'il comporte également une couche de benzocyclobutène (9) sur laquelle repose l'enroulement (20) formant inductance.

4. Circuit intégré monolithique selon la revendication 1, caractérisé en ce qu'il comporte également une couche de support en silice (16) sur laquelle repose l'enroulement (20) formant inductance.

5. Circuit intégré monolithique selon la revendication 4, caractérisé en ce que la couche de support (16) est séparée de la face supérieure de la couche de passivation par une couche de polyimide (9).

6. Circuit intégré monolithique selon la revendication 4, caractérisé en ce que la couche de support (16) est séparée de la face supérieure (6) de la couche de passivation (4) par une couche d'air.

7. Circuit intégré monolithique selon la revendication 1, caractérisé en ce que l'enroulement en cuivre (20) est recouvert d'une couche d'or (28) ou d'alliage à base d'or.

8. Circuit intégré monolithique selon la revendication 1, caractérisé en ce que l'espace entre deux spires consécutives de l'enroulement (20) est empli d'air.

9. Procédé de fabrication d'un circuit intégré monolithique incorporant un composant inductif, caractérisé en ce qu'il comprend les étapes suivantes dans lesquelles :
- on dépose une couche de polyimide (9) sur un substrat semi-conducteur (2) recouvert d'une couche de passivation (4), et comprenant des plots métalliques (5) connectés au substrat (2) et traversant la couche de passivation (4) pour affleurer sur la face supérieure (6) de ladite couche (4) ;
- on dépose une couche de silice (16), sur ladite couche de polyimide (9) ;
- on aménage des ouvertures (30) dans les couches de silice (16) et de polyimide (9), les dites ouvertures (30) débouchant sur les plots métalliques (5) ;
- on dépose sur l'ensemble une sous-couche de métal de croissance (33) ;
- on dépose une couche de résine photosensible sur la sous-couche de métal de croissance (33),
- on insole la résine et on élimine les zones destinées à former la face inférieure du composant inductif (20) ;
- on dépose par électrolyse sur les zones de la sous-couche de métal de croissance apparentes, une couche de cuivre destinée à former le ruban du composant inductif ;
- on élimine le reste de la résine photosensible et le reste de la sous-couche de métal de croissance.

10. Procédé de fabrication d'un circuit intégré monolithique incorporant un composant inductif, caractérisé en ce qu'il comprend les étapes suivantes dans lesquelles :
- on dépose une couche de benzocyclobutène (9) sur un substrat semi-conducteur (2) recouvert d'une couche de passivation (4), et comprenant des plots métalliques (5) connectés au substrat (2) et traversant la couche de passivation (4) pour affleurer sur la face supérieure (6) de ladite couche (4) ;
- on aménage des ouvertures (30) dans la couche de benzocyclobutène (9), les dites ouvertures (30) débouchant sur les plots métalliques (5) ;
- on dépose sur l'ensemble une sous-couche de métal de croissance (33) ;
- on dépose une couche de résine photosensible sur la sous-couche de métal de croissance (33),
- on insole la résine et on élimine les zones destinées à former la face inférieure du composant inductif (20) ;
- on dépose par électrolyse sur les zones de la sous-couche de métal de croissance apparentes, une couche de cuivre destinée à former le ruban du composant inductif ;
- on élimine le reste de la résine photosensible et le reste de la sous-couche de métal de croissance.

11. Procédé selon la revendication 9, caractérisé en ce qu'il comporte en outre, une étape d'élimination de la couche de polyimide (9).

12. Procédé selon l'une des revendications 9 à 11, caractérisé en ce qu'il comporte en outre une étape de passivation du ruban de cuivre par dépôt d'une couche d'or (28, 40) ou d'alliage à base d'or.

13. Procédé selon la revendication 9 ou 10, caractérisé en ce qu'il comporte une étape de dépôt d'un métal formant couche barrière (31) sur les plots métalliques.

14. Procédé selon la revendication 13, caractérisé en ce qu'il comporte une étape de dépôt d'une couche d'adaptation (32) sur la couche de métal barrière (31).
